Europäisches Patentamt

European Patent Office

Office européen des brevets

(11) Veröffentlichungsnummer: **0 393 745**
**A2**

(12) **EUROPÄISCHE PATENTANMELDUNG**

(21) Anmeldenummer: **90200855.6**

(22) Anmeldetag: **09.04.90**

(51) Int. Cl.5: **G01R 33/46, G01R 33/48, G01R 33/56**

(30) Priorität: **13.04.89 DE 3912142**

(43) Veröffentlichungstag der Anmeldung:
**24.10.90 Patentblatt 90/43**

(84) Benannte Vertragsstaaten:
**DE FR GB**

(71) Anmelder: **Philips Patentverwaltung GmbH**
**Wendenstrasse 35 Postfach 10 51 49**
**D-2000 Hamburg 1(DE)**
(84) **DE**

Anmelder: **N.V. Philips' Gloeilampenfabrieken**
**Groenewoudséweg 1**
**NL-5621 BA Eindhoven(NL)**
(84) **FR GB**

(72) Erfinder: **Bomsdorf, Hartwin, Dr.**
**Mansteinstrasse 30**
**D-2000 Hamburg 20(DE)**
Erfinder: **McKinnon, Graeme Colin, Dr.**
**Wiesliacher 12**
**CH-8053 Zürich(CH)**
Erfinder: **Bösiger, Peter, Dr.**
**CH-Ennetbaden**
**CH-Ennetbaden(CH)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Verfahren für die Kohlenstoff-Kernresonanz-Spektroskopie und Anordnung zur Durchführung des Verfahrens.**

(57) Die Erfindung beschreibt ein Verfahren zur lokalisierten Kohlenstoff-MR-Spektroskopie. Zu diesem Zweck werden vor einer zum Polarisationstransfer geeigneten Teilsequenz drei schichtselektive Impulse erzeugt, die die Kernmagnetisierung in nur einer Schicht beeinflussen.

Fig.2

## Verfahren für die Kohlenstoff-Kernresonanz-Spektroskopie und Anordnung zur Durchführung des Verfahrens

Die Erfindung betrifft ein Verfahren für die Kohlenstoff-Kernresonanz-Spektroskopie, bei dem in Anwesenheit eines homogenen stationären Magnetfeldes eine Anzahl von Sequenzen auf einen Untersuchungsbereich einwirkt, wobei jede Sequenz als erstes die Anregung der Protonen umfaßt, derart, daß zu einem Referenzzeitpunkt deren Kernmagnetisierung um 90° gekippt ist, wonach in definiertem zeitlichen Abstand von dem Referenzzeitpunkt die Kernmagnetisierung von Wasserstoff und Kohlenstoff durch weitere Hochfrequenzimpulse angeregt wird sowie eine Anordnung zur Durchführung dieses Verfahrens, wonach das dadurch erzeugte Kohlenstoff-Kernresonanzsignal einer Frequenzanalyse unterzogen wird.

Bei diesen Verfahren wirken im Untersuchungsbereich in jeder Sequenz zunächst Hochfrequenzimpulse mit der Larmorfrequenz von Protonen, die bei einer vorgegebenen Feldstärke etwa viermal so hoch ist wie die Larmorfrequenz von Kohlenstoff (d.h. des Isotops$^{13}$c). Durch diese Protonenanregung ergibt sich ein Polarisationstransfer, der dazu führt, daß die Kohlenstofflinien mit vergrößerter Amplitude auftreten, wenn sie nach diesem Transfer angeregt werden. Derartige Verfahren sind in der Literatur als DEPT- bzw. als INEPT-Verfahren bekannt (vergl. z.B. Kalinowski et al. "$^{13}$C-NMR-Spektroskopie", Thieme-Verlag,1984).

In der medizinischen Diagnostik ist es erforderlich, spektroskopische Untersuchungen durchzuführen, die nur einen Teil des gesamten Untersuchungsbereichs umfassen, bei spielsweise eine bestimmte Region im Schädel eines Patienten. Hierbei muß also der Bereich lokalisiert werden, aus dem das Spektrum bestimmt werden soll.

Es sind verschiedene Lokalisationsverfahren bekannt, beispielsweise das sogenannte VSE-Verfahren (J. Magn. Res. 56, 350-354 (1984)) oder das SPARS-Verfahren (J. Magn. Res., 67, 148.155 (1985)). Bei diesen Verfahren wird die Kernmagnetisierung im Bereich außerhalb dreier zueinander senkrechter Schichten dephasiert, so daß am Ende nur im Schnittbereich dieser drei Schichten die Kernmagnetisierung unbeeinflußt ist. Schließt man daran eine DEPT- oder INEPT-Sequenz an, dann ergibt diese Kombination das Kohlenstoffspektrum eines vorgebbaren Volumenbereiches.

In jüngster Zeit sind neuere Lokalisierungsverfahren entwickelt worden, wie STEVE (EP-A-233675) und VSR (EP-A-302550). Diese Verfahren eignen sich besser für die klinische Praxis; sie beeinflussen lediglich die Kernmagnetisierung in drei zueinander senkrechten Schichten und erzeugen ein Echosignal im Schnittbereich dieser drei Schichten. Deshalb ist es nicht ohne weiteres möglich, einer DEPT- oder INEPT-Sequenz - ähnlich wie bei VSE oder SPARS - eine VSR- oder STEVE-Sequenz voranzustellen.

Aufgabe der vorliegenden Erfindung ist es, eine Sequenz der eingangs genannten Art so zu modifizieren, daß eine Kombination mit einer der zuletzt genannten, vorangehenden Lokalisierungssequenzen zu einer Gesamtsequenz möglich ist. Diese Aufgabe wird erfindungsgemäß dadurch gelöst, daß zwecks Lokalisierung wenigstens drei schichtselektive Hochfrequenzimpulse mit der Larmorfrequenz von Wasser erzeugt werden, mit deren Hilfe im Referenzzeitpunkt im Schnittbereich der durch die drei schichtselektiven Hochfrequenzimpulse beeinflußten Schichten ein Echosignal erzeugt wird, das zwei Gruppen von Sequenzen mit jeweils der gleichen Zahl von Sequenzen ausgeführt werden, daß die Sequenzen der einen Gruppe gegenüber denjenigen der anderen Gruppe so modifiziert sind, daß die im Referenzzeitpunkt erzeugten Echosignale der einen Gruppe die entgegengesetzte Phase haben wie die Echosignale der anderen Gruppe und daß die Differenzen der Kohlenstoffkernresonanzsignale der beiden Gruppen summiert werden.

Die Erfindung basiert auf folgender Überlegung: Bei den bekannten DEPT- oder INEPT-Sequenzen werden die Protonen (im gesamten Untersuchungsbereich) zunächst durch einen 90°-Hochfrequenzimpuls angeregt. Dieser erste Hochfrequenzimpuls wird weggelassen und ersetzt durch eine vorangehende (STEVE- oder VSR-) Sequenz, die zu dem (Referenz-)Zeitpunkt, zu dem bei den bekannten DEPT- oder INEPT-Sequenzen der 90°-Hochfrequenzimpuls erzeugt wird, ein Echosignal erzeugt, d.h. im Schnittbereich zum Referenzzeitpunkt ein Maximum der Kernmagnetisierung hervorruft.

Die nach dem Polarisationstransfer erzeugte Kernresonanzanregung bei der Larmorfrequenz von Kohlenstoff wirkt nicht nur auf den Schnittbereich ein, sondern auf den gesamten Untersuchungsbereich. Um den Einfluß der außerhalb des Schnittbereichs liegenden Bereiche zu unterdrücken, wird bei der Erfindung ein sogenanntes Phasen-Cycling mit den beiden Gruppen von Sequenzen durchgeführt. Die Kohlenstoffkernresonanzsignale, die dabei von den beiden Gruppen erzeugt werden, haben eine entgegengesetzte Phasenlage, während die Kohlenstoffkernresonanzsignale aus den Bereichen außerhalb des Schnittbereichs die gleiche Phasenlage haben. Bildet man daher die Differenz zwischen den Kernresonanzsignalen beider Gruppen, dann werden die Signalkomponenten eliminiert, die von Bereichen außerhalb des Schnittbereichs herrühren.

Die Erfindung wird nachstehend anhand der Zeichnung näher erläutert. Es zeigen:

Fig. 1 ein Kernresonanzspektrometer, mit dem die Erfindung durchführbar ist,

Fig. 2 eine bekannte Variante eines INEPT-Verfahrens,

Fig. 3 eine Kombination der Sequenz nach Fig. 2 mit einer STEVE-Sequenz und

Fig. 4 die Kombination eines Verfahrens nach Fig. 2 mit einer VSR-Sequenz.

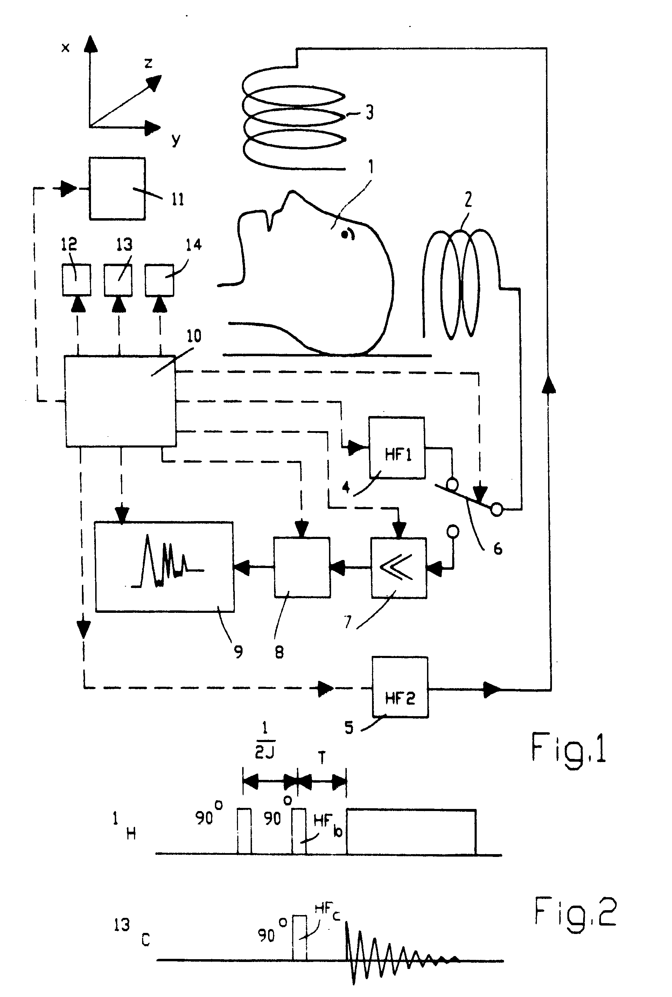

In Fig. 1 ist mit 1 ein im Untersuchungsbereich befindlicher Patient bezeichnet, der einem starken homogenen und stationären Magnetfeld ausgesetzt ist. Dieses in z-Richtung eines kartesischen x-y-z-Koordinatensystems verlaufende Magnetfeld wird von einem in der Zeichnung nur schematisch angedeuteten Magneten 11 erzeugt; in Wirklichkeit umschließt dieser Magnet den Untersuchungsbereich. Für Zwecke der Spektroskopie muß die Induktion dieses Magnetfeldes relativ stark sein und beispielsweise vier Tesla betragen. Bei vier Tesla beträgt die Larmorfrequenz von $^{13}C$-Kernen etwa 42,8 MHz, während die Larmorfrequenz von Protonen rund 170 MHz beträgt.

Das Gerät umfaßt einen ersten Hochfrequenzerzeuger 4, der Schwingungen mit der Larmorfrequenz des Kohlenstoffs erzeugt und über einen Schalter 6 mit einer ersten Hochfrequenzspule verbunden ist, die auf diese Frequenz abgestimmt ist und auf den Untersuchungsbereich einwirkt. Ein zweiter Hochfrequenzerzeuger erzeugt Schwingungen mit der Larmorfrequenz der (Wasserstoff-)Protonen und ist mit einer Hochfrequenzspule 3 verbunden, die ebenfalls im Untersuchungsbereich ein zu dem stationären Magnetfeld senkrecht verlaufendes Magnetfeld erzeugt.

Die im Untersuchungsbereich bei der Larmorfrequenz von Kohlenstoff entstehenden Kernresonanzsignale werden von der Spule 2 aufgenommen und über den Schalter 6 einem Empfänger 7 zugeführt. An den Ausgang des Empfängers 7 ist eine Auswerteschaltung 8 angeschlossen, die aus dem empfangenen Kernresonanzsignal mittels Fouriertransformation das Spektrum erzeugt, das auf einer geeigneten Wiedergabeeinheit 9 wiedergegeben werden kann. Die Komponenten 4..9 werden von einer Steuereinheit 10 gesteuert, die einen geeigneten Microcomputer oder dergleichen umfassen kann. Die Steuereinheit 10 steuert darüberhinaus noch die schematisch dargestellten Einheiten 12, 13 bzw. 14, die im Untersuchungsbereich ein in z-Richtung verlaufendes Magnetfeld mit einem in x-y- bzw. z-Richtung verlaufenden Gradienten erzeugen.

Fig. 2 zeigt in zwei Zeilen die zeitliche Lage der von den Spulen 3 und 2 erzeugten Hochfrequenzmagnetfelder bei einer vereinfachten Variante eines INEPT-Verfahrens. Dabei wird zunächst zur Zeit $t_r$ (erste Zeile) mit der Spule 3 ein $90°$-Hochfrequenzimpuls $HF_a$ erzeugt, der die Kernmagnetisierung der Protonen im Untersuchungsbereich um $90°$ kippt. Der Vektor dieser Kernmagnetisierung hat aufgrund der J-Kopplung zwischen den C-Atomen und den Protonen im Untersuchungsbereich zwei Komponenten mit voneinander abweichender Frequenz. Zur Zeit $T = 1/2J$ nach dem ersten $90°$-Hochfrequenzimpuls, zu der die beiden Komponenten gerade gegenphasig sind, wird ein weiterer $90°$-Hochfrequenzimpuls $HF_b$ erzeugt, der die eine Frequenzkomponente in $+z$-Richtung und die andere in $-z$-Richtung kippt. J ist die Stärke der J-Kopplung zwischen den Protonen und den Kohlenstoffatomen (in der Praxis rund 125 Hz).

Daraus ergibt sich ein Polarisationstransfer, der dadurch ausgenutzt werden kann, daß mit Spule 2 ein $90°$-Hochfrequenzimpuls $HF_c$ bei der Larmorfrequenz von Kohlenstoff erzeugt wird. Anschließend wird der Umschalter 6 umgeschaltet, das zur Zeit T nach dem zweiten Hochfrequenzimpuls der Spule 3 von der Spule 2 empfangene Kernresonanzsignal wird im Empfänger 7 verstärkt und demoduliert und in der Einheit 8 einer Fouriertransformation unterzogen, und das auf diese Weise erzeugte Spektrum wird auf dem Monitor 9 dargestellt. Würde man die beiden $90°$-Hochfrequenzimpulse der Spule 3 weglassen, so daß der Polarisationstransfer entfallen würde, hätte das in der Spule 2 induzierte Kernresonnzsignal eine um einen Faktor von rund 4 niedrigere Amplitude. Während des Empfangs des Kernresonanzsignals mit der Spule 2 wird mit der Hochfrequenzspule 3 ein Hochfrequenzmagnetfeld bei der Larmorfrequenz der Protonen erzeugt, durch das die Dublettstruktur der Kohlenstofflinien unterdrückt wird.

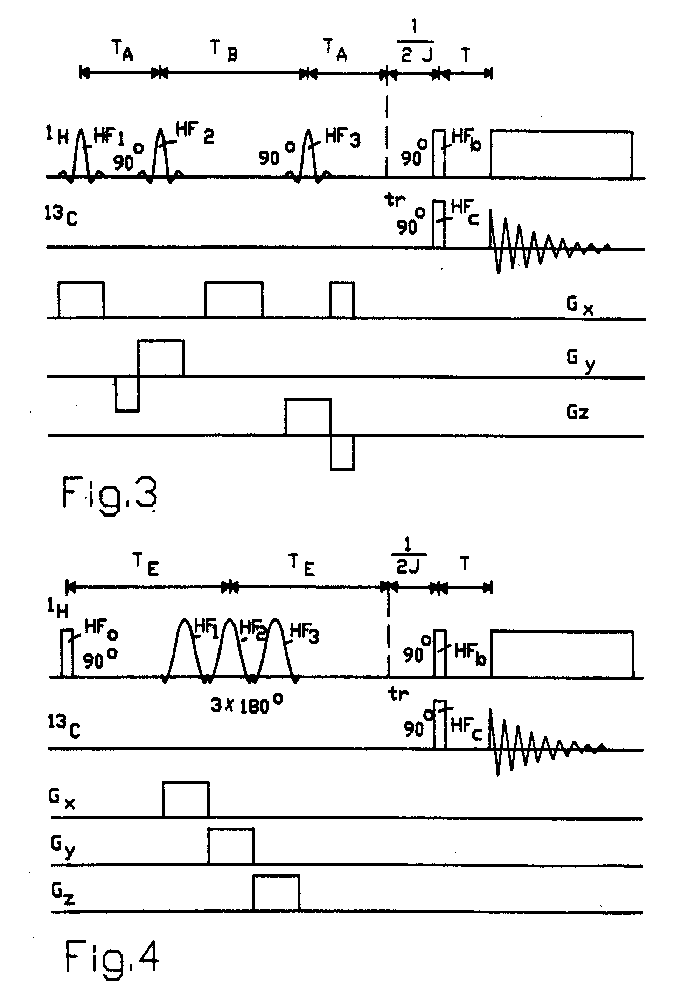

Die in Fig. 3 dargestellte kombinierte Sequenz besteht aus zwei Teilsequenzen. Die erste Teilsequenz entspricht einer sogennnten STEVE-Sequenz und dient zur Lokalisation. Sie umfaßt drei $90°$-Hochfrequenzimpulse (1. Zeile von Fig. 3) $HF_1$, $HF_2$ und $HF_3$. Während des ersten $90°$-Hochfrequenzimpulses $HF_1$ ist die Einheit 12 wirksam, so daß ein magnetisches Gradientenfeld $G_x$ mit in x-Richtung verlaufendem Gradienten erzeugt wird (3. Zeile). Während des zweiten Hochfrequenzimpulses - im Abstand $T_A$ vom ersten - ist die Einheit 13 wirksam, so daß ein magnetisches Gradientenfeld $G_y$ mit in y-Richtung verlaufendem Gradienten erzeugt wird, wie in der vierten Zeile von Fig. 3 angedeutet. Der dritte $90°$-Hochfrequenzimpuls $HF_3$, der im zeitlichen Abstand $T_B$ auf den zweiten folgt, wird von einem magnetischen Gradientenfeld $G_z$ mit in z-Richtung verlaufenden Gradienten begleitet, das von der Einheit 14 erzeugt wird. Die drei Hochfrequenzimpulse regen die Kernmagnetisierung in drei zueinander senkrechten Schichten an. Alle Kernresonanzsignale, die nicht aus dem Schnittbereich dieser drei Schichten stammen, werden dabei durch ein magnetisches Gradientenfeld mit in x-Richtung verlaufendem Gradienten dephasiert, die zwischen dem zweiten und dem dritten Hochfrequenzimpuls sowie nach dem dritten Hochfrequenzimpuls wirksam sind. Wie im einzelnen in der EP-A-233675 dargelegt, wird lediglich das aus dem Schnittbereich der drei Schichten stammende stimulierte Echosignal nicht dephasiert. Dieses tritt bekanntlich zu einer Zeit $T_A$ nach dem dritten Hochfrequenzimpuls auf, die dem zeitlichen Abstand zwischen den beiden ersten Hochfrequenzimpulsen entspricht.

Die sich daran anschließende Teilsequenz unterscheidet sich von derjenigen nach Fig. 2 lediglich dadurch, daß der erste Hochfrequenzimpuls $HF_a$ weggelassen ist. Die Lage dieser Teilsequenz ist in bezug auf die vorangehende Teilsequenz ($HF_1..HF_3$) so gewählt, daß der Referenzzeitpunkt $t_r$, zu dem bei der Sequenz nach Fig. 2 der erste 90°-Hochfrequenzimpuls auftritt, mit dem Zeitpunkt identisch ist, an dem das stimulierte Echosignal aus dem Schnittbereich der durch die drei schichtselektiven Hochfrequenzimpulse $HF_1..HF_3$ auftritt. Dieser Referenzzeitpunkt liegt somit um den Zeitraum $T_A$ nach dem dritten Hochfrequenzimpuls $HF_3$ und um den Zeitraum 1/2 J vor den Hochfrequenzimpuls $HF_b$. Im Referenzzeitpunkt wird zwar nicht, wie bei der Sequenz nach Fig. 2, ein Hochfrequenzimpuls erzeugt, doch ist auch hierbei im Referenzzeitpunkt in dem durch drei Hochfrequenzimpulse $HF_1..HF_3$ und die sie begleitenden magnetischen Gradientenfelder $G_x..G_z$ bestimmten Schnittbereich eine transversale Magnetisierung vorhanden.

Der Hochfrequenzimpuls $HF_c$ mit der Kohlenstofflarmorfrequenz wirkt nicht nur im Schnittbereich der drei Schichten in dem der Polarisationstransfer stattgefunden hat auf die Kohlenstoffeatom ein, sondern auch außerhalb dieses Schnittbereichs (in dem kein Polarisationstransfer stattgefunden hat). Das bei jeder Sequenz zur Zeit T nach den Hochfrequenzimpulsen $HF_b$ und $HF_c$ in der Spule 2 induzierte Kohlenstoffkernresonanzsignal enthält daher neben Komponenten aus dem Schnittbereich auch Komponenten, die von dem Untersuchungsbereich außerhalb des Schnittbereichs beeinflußt werden. Die letzteren Komponenten sind unerwünscht, weil sie die Lokalisation verhindern. Sie werden mit Hilfe eines "Phasen-Cyclings" unterdrückt, daß die Durchführung zweier unterschiedlicher Gruppen von Sequenzen beinhaltet.

Die Sequenzen der einen Gruppe unterscheiden sich von den Sequenzen der anderen Gruppe dadurch, daß der Polarisationstransfer um 180° versetzt erfolgt. Dies läßt sich beispielsweise dadurch erreichen, daß in der einen Gruppe der erste Hochfrequenzimpuls $HF_1$ die gleiche Phasenlage hat wie die Hochfrequenzimpulse $HF_2$ und $HF_3$ und in der anderen Gruppe die entgegengesetzte Phasenlage. Dadurch ändert sich die Phasenlage des zum Referenzzeitpunkt auftretenden Echosignals um 180°. Infolgedessen sind in dem zur Zeit T auftretenden Kohlenstoff-Kernresonanzsignal bei den beiden Sequenzen Komponenten aus dem Schnittbereich mit entgegengesetzter Phasenlage und von Bereichen außerhalb des Schnittbereichs herrührende Komponenten mit gleicher Phasenlage vorhanden. Diese letztgenannten unerwünschten Komponenten werden dadurch unterdrückt, daß die Kohlenstoffkernresonanzsignale beider Sequenzen voneinander subtrahiert werden. Wird dies wiederholt und werden die dabei gebildeten Differenzen summiert, dann hängt das so gebildete Summensignal nur von den Kohlenstofftomen im Schnittbereich ab - und dies, obwohl die Lokalisation durch die drei Impulse $HF_1..HF_3$ bei der Larmorfrequenz der Protonen erfolgte. Das so gebildete, die Differenzen summierende Signal wird durch Fouriertransformation frequenzanalysiert.

Diese Lokalisation durch drei schichtselektive Hochfrequenzimpulse mit der Protonenlarmorfrequenz ist genauer als eine Lokalisation durch schichtselektive Impulse mit der Kohlenstofflarmorfrequenz, weil die Bandbreite der Protonen-Kernresonanzsignale wesentlich geringer ist als die Bandbreite der Kohlenstoff-Kernresonanzsignale. - In Fig. 3 ist nur eine einzige Sequenz dargestellt; auf eine Darstellung der zu den beiden verschiedenen Gruppen von Sequenzen gehörenden Sequenzen wurde verzichtet, da sie - abgesehen von den Phasenbeziehungen zwischen den einzelnen Hochfrequenzimpulsen -identisch sind.

Die drei schichtselektiven Hochfrequenzimpulse $HF_1..HF_3$ können auch bei anderen DEPT- oder INEPT-Sequenzen als der in Fig. 2 dargestellten benutzt werden. Dazu muß lediglich deren ersten Hochfrequenzimpuls mit der Larmorfrequenz von Wasserstoff weggelassen werden, und das stimulierte Echosignal muß zu dem Referenzzeitpunkt auftreten, zu dem bei der betreffenden DEPT- bzw. INEPT-Sequenz der erste 90°-Hochfrequenzimpuls erzeugt werden muß.

Bei der in Fig. 4 dargestellten Sequenz wird zunächst ein 90°-Hochfrequenzimpuls $HF_0$ mit der Larmorfrequenz von Wasserstoff erzeugt; während dieses Hochfrequenzimpulses ist kein magnetisches Gradientenfeld wirksam. Diesem Hochfrequenzimpuls folgen drei Hochfrequenzimpulse $HF_1$, $HF_2$ und $HF_3$ mit der Larmorfrequenz von Wasser, die von einem magnetischen Gradientenfeld mit einem in x-y- bzw. z-Richtung verlaufenden Gradienten begleitet werden (vergleiche 3. bis 5. Zeile von Fig. 4). Die drei Hochfrequenzimpulse $HF_1..HF_3$ haben den gleichen Abstand voneinander, wobei der mittlere Hochfrequenzimpuls $HF_2$ von dem Hochfrequenzimpuls $HF_0$ den Abstand $T_E$ hat. Die drei schichtselektiven Hochfrequenzimpulse $HF_1..HF_3$ erzeugen in Verbindung mit dem Hochfrequenzimpuls $HF_0$ ein Spin-Echo-Signal in dem Schnittbereich der durch die drei Impulse $HF_1..HF_3$ beeinflußten Schichten. Die Kernresonanzsignale der außerhalb dieses Schnittbereiches liegenden Regionen werden durch die während der drei 180°-Hochfrequenzimpulse wirksamen Gradientenfelder $G_x$, $G_y$ und $G_z$ dephasiert. Das Spin-Echo-Signal tritt zur Zeit $T_E$ nach dem zweiten Hochfrequenzimpuls $HF_2$ auf. Die (durch Weglassung des ersten Hochfrequenzimpulses $HF_a$) modifizierte Sequenz nach Fig. 2 wird so an die Hochfrequenzimpulse $HF_0..HF_3$ angehängt, daß der Referenzzeitpunkt $t_R$ im Abstand $T_E$ vom zweiten Hochfrequenzimpuls $HF_2$ liegt und von dem nachfolgenden Hochfrequenzimpuls $HF_b$ den zeitlichen Abstand 1/2J hat.

Das in der Spule 2 induzierte Kernresonanzsignal wird von den $^{13}C$-Kernen im gesamten Untersuchungsbereich bestimmt. Um ein Signal zu erhalten, das nur von dem durch den Polarisationstransfer beeinflußten Schnittbereich abhängt, wird ein Phasen-Cycling durchgeführt, wie schon in Verbindung mit Fig. 3 erläutert. Dies läßt sich am einfachsten dadurch realisieren, daß bei den Sequenzen der einen Gruppe der erste Hochfrequenzimpuls $HF_0$ jeweils die gleiche Phasenlage hat wie die Hochfrequenzimpulse $HF_1..HF_3$, während bei den Sequenzen der zweiten Gruppe der erste Hochfrequenzimpuls $HF_0$ die entgegengesetzte Phasenlage hat wie die Hochfrequenzimpulse $HF_1..HF_3$. Bildet man wiederum die Differenz zwischen den Kohlenstoffkernresonanzsignalen, die bei den Sequenzen der verschiedenen Gruppen erzeugt werden und summiert die Differenzen, dann ergibt sich ein Kernresonanzsignal, das nur von den $^{13}C$-Kernen im Schnittbereich der drei durch die drei Hochfrequenzimpulse $HF_1..HF_3$ angeregten Schichten bestimmt ist.

Auch hier ist wieder eine Kombination mit anderen DEPT-bzw. INEPT-Sequenzen als der in Fig. 2 dargestellten möglich, indem man die Teilsequenzen so aufeinanderfolgen läßt, daß das Spin-Echo-Signal aus dem Schnittbereich zu dem Zeitpunkt auftritt, an dem bei der betreffenden DEPT-bzw. INEPT-Sequenz der erste (für die Lokalisation weggelassene) 90°-Hochfrequenzimpuls auftritt.

**Ansprüche**

1. Verfahren für die Kohlenstoff-Kernresonanz-Spektroskopie, bei dem in Anwesenheit eines homogenen stationären Magnetfeldes eine Anzahl von Sequenzen auf einen Untersuchungsbereich einwirkt, wobei jede Sequenz als erstes die Anregung der Protonen umfaßt, derart, daß zu einem Referenzzeitpunkt ($t_r$) deren Kernmagnetisierung um 90° gekippt ist, wonach in definiertem zeitlichen Abstand von dem Referenzzeitpunkt die Kernmagnetisierung von Wasserstoff und Kohlenstoff durch weitere Hochfrequenzimpulse ($HF_b$, $HF_c$) angeregt wird, wonach das dadurch erzeugte Kohlenstoff-Kernresonanzsignal einer Frequenzanalyse unterzogen wird,
dadurch gekennzeichnet, daß zwecks Lokalisierung wenigstens drei schichtselektive Hochfrequenzimpulse ($HF_1..HF_3$) mit der Larmorfrequenz von Wasser erzeugt werden, mit deren Hilfe im Referenzzeitpunkt im Schnittbereich der durch die drei schichtselektiven Hochfrequenzimpulse beeinflußten Schichten ein Echosignal erzeugt wird, daß zwei Gruppen von Sequenzen mit jeweils der gleichen Zahl von Sequenzen ausgeführt werden, daß die Sequenzen der einen Gruppe gegenüber denjenigen der anderen Gruppe so modifiziert sind, daß die im Referenzzeitpunkt erzeugten Echosignale der einen Gruppe die entgegengesetzte Phase haben wie die Echosignale der anderen Gruppe und daß die Differenzen der Kohlenstoff-Kernresonanzsignale der beiden Gruppen summiert werden.

2. Verfahren nach Anspruch 1,
dadurch gekennzeichnet, daß die drei schichtselektiven Hochfrequenzimpulse 90°-Hochfrequenzimpulse ($HF_1..HF_3$) sind, daß der zeitliche Abstand ($T_A$) zwischen den beiden ersten Hochfrequenzimpulsen ($HF_1..HF_2$) dem zeitlichen Abstand des dritten ($HF_3$) dieser drei schichtselektiven Hochfrequenzimpulse vom Referenzzeitpunkt ($T_r$) entspricht und daß zwischen den drei Hochfrequenzimpulsen sowie zwischen dem dritten und dem Referenzzeitpunkt magnetische Gradientenfelder mit solcher Amplitude und Dauer wirksam gemacht werden, daß bis auf das stimulierte Echosignal aus dem Schnittbereich der drei Schichten alle Kernresonanzsignale durch Dephasierung unterdrückt werden.

3. Verfahren nach Anspruch 2,
dadurch gekennzeichnet, daß der erste der drei schichtselektiven Hochfrequenzimpulse bei der einen Gruppe von Sequenzen die gleiche und bei der anderen Gruppe von Sequenzen die entgegengesetzte Phasenlage hat wie die beiden anderen schichtselektiven Hochfrequenzimpulse ($HF_2$, $HF_3$).

4. Verfahren nach Anspruch 1,
dadurch gekennzeichnet, daß die Sequenz einen 90°-Hochfrequenzimpuls ($HF_0$) umfaßt, dem drei schichtselektive 180°-Hochfrequenzimpulse ($HF_1..HF_3$) im gleichen zeitlichen Abstand voneinander folgen, und daß der zeitliche Abstand ($T_E$)

zwischen dem 90°-Hochfrequenzimpuls und dem zweiten 180°-Impuls so groß ist wie der zeitliche Abstand zwischen dem zweiten Hochfrequenzimpuls (HF₂) und dem Refrenzzeitpunkt (t_r).

5. Verfahren nach Anspruch 4, dadurch gekennzeichnet, daß der den drei schichtselektiven 180° Hochfrequenzimpulsen (HF₁..HF₃) vorangehende Hochfrequenzimpuls (HF₀) bei der einen Gruppe die gleiche und bei der anderen Gruppe von Sequenzen die entgegengesetzte Phasenlage hat wie die drei Hochfrequenzimpulse.

6. Anordnung zur Durchführung des Verfahrens nach Anspruch 1 mit einem Magneten (11) zur Erzeugung eines homogenen stationären Magnetfeldes und mit Mitteln zum Erzeugen bzw. Empfangen hochfrequenter Magnetfelder (3,2) bei den Larmorfrequenzen von Wasserstoff und Kohlenstoff und mit Mitteln (12..14) zum Erzeugen von magnetischen Gradientenfeldern mit in drei zueinander senkrechten Richtungen verlaufenden Gradienten sowie mit einer Steuereinheit zur Steuerung der Mittel, dadurch gekennzeichnet, daß die Steuereinheit so programmiert ist, daß zunächst drei schichtselektive Hochfrequenzimpulse (HF₁..HF₃) bei der Larmorfrequenz von Wasser erzeugt werden, wonach mindestens je ein Hochfrequenzimpuls (HF_b,HF_c) bei der Larmorfrequenz von Wasserstoff bzw. Kohlenstoff erzeugt wird und das im Schnittbreich der drei Schichten entstehende Kernresonanzsignal mit der Larmorfrequenz von Kohlenstoff des Spektrums herangezogen werden.

Fig.1

Fig.2

1-Ⅱ-PHD 89-052

Fig.3

Fig.4